(19)

Europäisches
Patentamt
European
Patent Office
Office européen
des brevets

(11) **EP 3 845 603 A1**

(12) **EUROPEAN PATENT APPLICATION**
published in accordance with Art. 153(4) EPC

(43) Date of publication:
 **07.07.2021 Bulletin 2021/27**

(21) Application number: **19815432.0**

(22) Date of filing: **04.06.2019**

(51) Int Cl.:
 *C08L 77/02* (2006.01)  *C08K 3/02* (2006.01)
 *C08K 3/38* (2006.01)  *C08K 5/3412* (2006.01)
 *C09C 1/00* (2006.01)  *C09C 3/10* (2006.01)

(86) International application number:
 **PCT/JP2019/022234**

(87) International publication number:
 **WO 2019/235496 (12.12.2019 Gazette 2019/50)**

(84) Designated Contracting States:
 **AL AT BE BG CH CY CZ DE DK EE ES FI FR GB GR HR HU IE IS IT LI LT LU LV MC MK MT NL NO PL PT RO RS SE SI SK SM TR**
 Designated Extension States:
 **BA ME**
 **KH MA MD TN**

(30) Priority: **05.06.2018 JP 2018107560**

(71) Applicant: **Teijin Limited**
 **Osaka 530-0005 (JP)**

(72) Inventors:
 • **MOYORI, Takaya**
  **Osaka-shi, Osaka 530-0005 (JP)**
 • **CHOKAI, Masayuki**
  **Osaka-shi, Osaka 530-0005 (JP)**
 • **IKEDA, Yoshinori**
  **Osaka-shi, Osaka 530-0005 (JP)**
 • **MAEDA, Masanori**
  **Osaka-shi, Osaka 530-0005 (JP)**

(74) Representative: **Cockerton, Bruce Roger**
 **Carpmaels & Ransford LLP**
 **One Southampton Row**
 **London WC1B 5HA (GB)**

(54) **COMPOSITE PARTICLES AND PRODUCTION METHOD THEREFOR**

(57)  An object of the present disclosure is to provide a composite particle having sufficient insulating properties and high thermal conductivity, and further to provide a composite particle having excellent handling property and moldability.
 The present invention relates to a random-shaped composite particle in which primary particles of the inorganic filler are aggregated and the primary particles are coated with a thermoplastic resin, and a method for producing thereof, as well as a molded article and a method for producing thereof.

**EP 3 845 603 A1**

**Description**

TECHNICAL FIELD

The present disclosure relates to a composite particle having an inorganic filler coated with a thermoplastic resin, and a method for producing the same.

BACKGROUND

Semiconductors are being mounted in high density and the amount of heat generation is being increased as a result of a miniaturization, a capacity enlargement and a performance enhancement of electronic equipment which uses the semiconductors. In this context, it has become an important issue how to ensure the heat dissipation. For example, in order to ensure the stable operation of the semiconductors used in a central processing unit of the personal computer or used to control the motor of the electric vehicle, it is indispensable to use a heat sink or a heat radiating fin for heat dissipation. There is a need for a material having both insulating property and thermal conductivity as a member used to couple the semiconductor and the heat sink.

In general, a printed circuit board used to mound the semiconductor is an insulating material, and an organic material is widely used for the printed circuit board. Although these organic materials had high insulation property, the thermal conductivity thereof was low; therefore, these organic materials made little contribution to the heat dissipation of the semiconductor. On the other hand, an inorganic material such as inorganic ceramics may be used to dissipate heat from the semiconductor. Although these inorganic materials have high thermal conductivity, their insulating properties are not high compared with organic materials. Therefore, a material capable of achieving both high insulation and high thermal conductivity is required as a material used for the printed circuit board.

As a method for improving the thermal conductivity of a thermally conductive material, there is known a method in which a filler of an insulating ceramic, such as aluminum oxide powder or aluminum nitride powder, is added to a matrix resin (Patent Documents 1 to 3).

Further, a method of mixing a fluidity modifier to improve the fluidity of a filler is known (Patent Document 4). Further, Patent Document 5 discloses a thermally conductive resin composition having polyamide fibers, boron nitride and aramid fibers in a prescribed percentage, respectively.

[RELATED ART]

[PATENT LITERATURE]

[Patent Document 1] JP-A-2002-280498
[Patent Document 2] JP-A-2003-342021
[Patent Document 3] JP-A-2005-209765
[Patent Document 4] JP-A-H10-204300
[Patent Document 5] JP-A-2010-116518

SUMMARY

[PROBLEM TO BE SOLVED BY THE INVENTION]

In order to obtain a resin composition having high thermal conductivity, it is necessary to fill a large amount of filler into a resin. However, when the dispersibility of the filler is low, voids are generated in a resin-molded article, and there is a problem that the impact resistance is lowered due to the voids and that the high thermal conductivity is not achieved.

In such a background, an object of the present disclosure is to provide a composite particle having sufficient insulating properties and high thermal conductivity, and further to provide a composite particle having excellent handling property and moldability.

[SOLUTION TO THE PROBLEM]

The object of the present invention is achieved by the following embodiments according to the present disclosure.

<Embodiment 1> A method for producing a random-shaped composite particle formed of aggregated primary particles of an inorganic filler, in which the primary particles are coated with a thermoplastic resin, comprising:

(1) providing a mixture comprising the inorganic filler and a monomer and/or oligomer of the thermoplastic resin, wherein said monomers and/or oligomers are in a liquid-state and cover the primary particles of the inorganic filler; and
(2) polymerizing the monomer and/or oligomer to form a random-shaped composite particle in which the primary particles of the inorganic filler are aggregated and the primary particles are coated with the thermoplastic resin.

<Embodiment 2> The method according to embodiment 1, wherein the monomer and/or oligomer of the thermoplastic resin is a cyclic compound capable of undergoing ring-opening polymerization.
<Embodiment 3> The method according to embodiment 2, characterized in that the thermoplastic resin is generated by ring-opening polymerization of the cyclic compound capable of undergoing ring-opening polymerization in a state of a mixture of the cyclic compound and the inorganic filler.
<Embodiment 4> The method according to any one of embodiments 1 to 3, wherein the thermoplastic resin is a polyamide.
<Embodiment 5> The method according to any one of embodiments 2 to 4, wherein the cyclic compound is $\varepsilon$-caprolactam and/or $\omega$-laurolactam.
<Embodiment 6> The method according to any one of embodiments 1 to 5, wherein the inorganic filler is a boron nitride particle or a silicone particle provided with a coating of an insulating layer.
<Embodiment 7> A random-shaped composite particle formed of aggregated primary particles of an inorganic filler, in which the primary particles are coated with a thermoplastic resin.
<Embodiment 8> The composite particle according to embodiment 7, comprising 51.0 to 99.9% by volume of the inorganic filler and 49.0 to 0.1% by volume of the thermoplastic resin.
<Embodiment 9> The composite particle according to embodiment 7 or 8, wherein the average particle diameter of the composite particle is $1\mu$m to $1000\mu$m.
<Embodiment 10> The composite particle according to any one of embodiments 7 to 9, wherein the thermoplastic resin is a polyamide.
<Embodiment 11> The composite particle according to embodiment 10, wherein the polyamide is polyamide 6, polyamide 12 or polyamide 612.
<Embodiment 12> The composite particle according to any one of embodiments 7 to 11, wherein the inorganic filler is a boron nitride particle or a silicone particle provided with a coating of an insulating layer.
<Embodiment 13> The composite particle according to any one of embodiments 7 to 12, wherein the thermoplastic resin is a thermoplastic resin generated by a ring-opening polymerization of a cyclic compound capable of undergoing ring-opening polymerization in a state of a mixture of the inorganic filler and the cyclic compound.
<Embodiment 14> A method for producing a molded article comprising pressing the composite particles according to any one of embodiments 7 to 13.
<Embodiment 15> A molded article obtained by pressing the composite particles according to any one of embodiments 7 to 13.
<Embodiment 16> The molded article according to embodiment 15, which is in the form of a sheet.

[Effect of the Invention]

According to the invention of the present disclosure, it is possible to provide a composite particle having sufficient insulating properties and high thermal conductivity. Further, according to the present invention, it is possible to provide a composite particle excellent in handling and moldability.

BRIEF DESCRIPTION OF THE DRAWINGS

[Figure 1] Fig.1 is a conceptual diagram of a method for producing the composite particle according to the present disclosure;
[Figure. 2] Fig.2 is a conceptual diagram of a method for producing a thermoplastic resin composition having a filler according to the prior art;
[Figure 3] FIG. 3 is a cross-sectional schematic view of the composite particle according to the present disclosure.
[Figure 4] Fig.4 is a cross-sectional schematic view of one aspect of a thermoplastic resin composition having a filler according to the prior art.

[Figure 5] Fig.5 is a cross-sectional schematic view of another aspect of a thermoplastic resin composition having a filler according to the prior art.

[Figure 6] FIG. 6 is a conceptual diagram of a manufacturing process of a molded article formed of the composite particle according to the present disclosure.

[Figure 7] FIG. 7 shows a cross-section of the composite particle according to the present disclosure, observed by SEM.

DESCRIPTION OF EMBODIMENTS

<<Method for producing a composite particle>>

The method according to the present disclosure is a method for producing a random-shaped composite particle formed of aggregated primary particles of an inorganic filler, in which the primary particles are coated with a thermoplastic resin; the method comprises the following steps:

(1) a provision step, in which a mixture comprising an inorganic filler and a monomer and/or oligomer of a thermoplastic resin are provided, and

(2) a reaction step, in which the monomer and/or oligomer are subjected to a polymerization reaction to form a random-shaped composite particle in which the primary particles of the inorganic filler are aggregated and the primary particles are coated with the thermoplastic resin,

wherein, in the above provision step, the monomer and/or oligomer are in a liquid state and cover the primary particles of the inorganic filler.

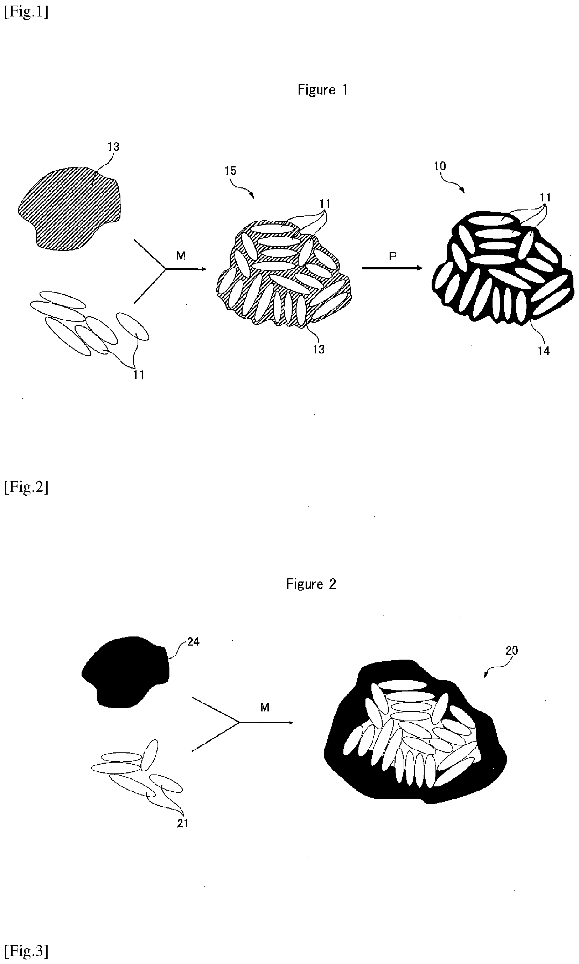

Fig.2 is a conceptual diagram of a method according to the prior art for producing a thermoplastic resin composition containing a filler. In this method, a thermoplastic resin composition 20 is produced by mixing a thermoplastic resin 24 and an inorganic filler 21 ("M" in FIG. 2). In this method, since the thermoplastic resin has a relatively high viscosity in general, the thermoplastic resin cannot be sufficiently impregnated between the primary particles of the inorganic filler 21. In addition, in such a method, it may be difficult to prepare a particulate thermoplastic resin composition.

On the other hand, the present disclosure makes use of the fact that a liquid monomer and/or oligomer, which is a raw material of a thermoplastic resin, has a low viscosity.

Fig.1 is a conceptual diagram of a method for producing a composite particle according to the present disclosure; In the method according to FIG. 1, first, a liquid-state monomer and/or oligomer 13 of a thermoplastic resin and primary particles 11 of an inorganic filler are mixed and stirred ("M" in FIG. 1) to obtain a mixture 15 in which the primary particles 11 of the inorganic filler are coated with the monomer and/or oligomer 13. Then, the mixture is for example subjected to heat treatment under an inert atmosphere, and the monomer and/or oligomer is subjected to a polymerization reaction ("P" in FIG. 1), in order to obtain a composite particle 10 having a thermoplastic resin 14 and primary particles 11 of inorganic filler. In this composite particle 10, the primary particles 11 of the inorganic filler are coated with the thermoplastic resin 14, and the primary particles 11 of the inorganic filler are aggregated by bonding to each other via the thermoplastic resin 14.

According to the manufacturing method of the present disclosure, by impregnating an inorganic filler with a liquid-state monomer and/or oligomer having low viscosity, the monomer and/or oligomer can be sufficiently impregnated into the inorganic filler. Then, by polymerizing the monomer and/or oligomer in this state to form a polymer, a composite particle can be obtained, in which the inorganic fillers retaining an aggregated state is tightly coated with the thermoplastic resin.

Although there is no intention to limit the invention by theory, it is considered that in the composite particles obtained by the manufacturing method according to the present disclosure, the aggregated state of the primary particles of the inorganic filler is retained, and as a result of that, the high thermal conductivity of the composite particle is brought about. In other words, the composite particles according to the present disclosure makes use of the aggregated inorganic filler, thereby effectively exhibiting high thermal conductivity.

Further, although there is no intention to limit the invention by theory, in the composite particle obtained by the manufacturing method according to the present disclosure, since the primary particles of the inorganic filler are covered with the thermoplastic resin, it is considered that the inorganic filler and the thermoplastic resin are in a highly mixed state. Therefore, it is considered that, for example, in a molded article formed of the composite particles according to the present disclosure, the inorganic fillers can be uniformly dispersed in the thermoplastic resin. Therefore, according to the method of the present disclosure, a composite particle having excellent moldability is provided.

In addition, since the inorganic fillers are covered with the thermoplastic resin, the composite particle obtained by the manufacturing method according to the present disclosure has high insulation property.

Further, since the composite particle obtained by the manufacturing method according to the present disclosure is particulate, it exhibits excellent handling property in a molding process or the like.

Therefore, according to the manufacturing method of the present disclosure, it is possible to provide a composite particle having sufficient insulating properties and high thermal conductivity. Further, according to the present invention, it is possible to provide a composite particle excellent in handling and moldability.

<Composite particles>

According to the manufacturing method of the present disclosure, it is possible to produce a random-shaped composite particle formed of aggregated primary particles of an inorganic filler, in which the primary particles are coated with a thermoplastic resin.

For details of the composite particles produced by this method, reference can be made to the description below of the composite particles.

<Provision step>

In the provision step of the manufacturing method according to the present disclosure, a mixture comprising an inorganic filler and a monomer and/or oligomer of a thermoplastic resin is provided.

(Inorganic filler)

The inorganic filler includes, for example, a particle of aluminum nitride, silica, alumina, magnesium oxide, silicon nitride, boron nitride, or zinc oxide, or a silicone particle provided with a coating of an insulating layer. Among these, preferred inorganic fillers are a boron nitride particle or a silicone particle provided with a coating of an insulating layer. As the boron nitride, it is possible to use either hexagonal boron nitride or cubic boron nitride. From the viewpoint of obtaining excellent thermal conductivity, hexagonal boron nitride is preferred.

The inorganic filler may be used alone or in combination. The shape of the primary particle of the inorganic filler is not limited, and may have for example a spherical, scaly, or fibrous shape.

The particle size of the primary particle of the inorganic filler is 0.1 to 200$\mu$m, 1 to 100$\mu$m, and preferably 10 to 50$\mu$m as an average particle diameter.

The particle size of the aggregated particle of the inorganic filler, i.e., the particle size of the composite particle, is 1 to 1000$\mu$m, preferably 10 to 500$\mu$m, as the average particle size.

The mean particle size of the composite particle can be measured by dispersing the composite particle in water and by using a laser diffraction/scattering particulate distribution analyzer (e.g., MT3000 manufactured by MicrotracBEL Corp.) as a measuring device.

(Thermoplastic resin)

Examples of the thermoplastic resin include polyamide, polyester, polycarbonate, polyether, polysulfide, and polyarylene ether ketone (PAEK), and polyamide is preferably used. Particularly preferred as polyamides are polyamide 6, polyamide 12, and polyamide 612. Examples of the polyarylene ether ketone (PAEK) include polyether ketone (PEK), polyether ether ketone (PEEK), polyether ketone ketone (PEKK), and polyether ether ketone ketone (PEEKK).

It is preferable that the composite particle obtained by the manufacturing method of the present disclosure comprises 51.0% by volume to 99.9% by volume of the inorganic filler and 49.0% by volume to 0.1% by volume of the thermoplastic resin. If the amount of the inorganic filler is too small or the amount of thermoplastic resin is too large, the particles aggregate and grow too large, and it becomes difficult to form the shape of a particle, which is not preferable. If the amount of inorganic filler is too large or the amount of thermoplastic resin is too small, the thermoplastic resin cannot coat the inorganic filler, which is not preferable.

Preferably, in one embodiment of the composite particle obtained by the manufacturing method according to the present disclosure, the inorganic filler is 51.0% by volume or more, 55.0% by volume or more, 60.0% by volume or more, 65.0% by volume or more, or 70.0% by volume or more, and/or 99.9% by volume or less, 99.0% by volume or less, 95.0% by volume or less, 90.0% by volume or less, 85.0% by volume or less, 80.0% by volume or less, or 75.0% by volume or less, and the thermoplastic resin is 0.1% by volume or more, 1.0% by volume or more 5.0% by volume or more, 10.0% by volume or more, 15.0% by volume or more, 20.0% by volume or more, or 25.0% by volume or more, and/or 49.0% by volume or less, 45.0% by volume or less, 40.0% by volume or less, 35.0% by volume or less, or 30.0% by volume or less.

Preferably, the proportion of the inorganic filler and the monomer and/or oligomer of the thermoplastic resin in the provision step may be determined so that the proportion of the inorganic filler and the thermoplastic resin falls within the above range.

(Monomer and/or oligomer of the thermoplastic resin)

The monomer and/or oligomer of the thermoplastic resin produces a thermoplastic resin by a polymerization reaction. For example, the monomer and/or oligomer of the thermoplastic resin may be a monomer and/or oligomer which, by polymerization, produces polyamide, polyester, polycarbonate, polyether, polysulfide, or polyarylene ether ketone (PAEK). Examples of the polyarylene ether ketone (PAEK) include polyether ketone (PEK), polyether ether ketone (PEEK), polyether ketone ketone (PEKK), and polyether ether ketone ketone (PEEKK).

The monomer and/or oligomer of the thermoplastic resin is not limited to one type, and may be a mixture of one or more of monomers and/or oligomers.

The oligomer of the thermoplastic resin has a structure obtained by polymerizing 100 or less, 50 or less, 30 or less, 10 or less, or 5 or less of one or more kinds of monomers, and has a repeating unit constituting the thermoplastic resin.

(Cyclic compounds)

In one embodiment according to the present disclosure, the thermoplastic resin consists of a polymer obtained from a ring-opening polymerization reaction. Namely, a cyclic compound which can be polymerized by a ring-opening polymerization reaction is used as a raw material of a thermoplastic resin. In other words, in one embodiment according to the present disclosure, the monomer and/or oligomer of the thermoplastic resin is a cyclic compound capable of undergoing ring-opening polymerization.

The cyclic compound which is capable of undergoing ring-opening polymerization reaction includes, for example, a cyclic amide, a cyclic ester, a cyclic carbonate, a cyclic ether, or a cyclic sulfide can be used. Particularly preferred cyclic compounds are $\epsilon$-caprolactam, and/or $\omega$-laurolactam.

Further, examples of the cyclic compound include cyclic oligomers composed of a repeating unit constituting a polymer such as polyester, polycarbonate, polysulfide, and polyarylene Ether ketone (PAEK). Examples of the polyarylene ether ketone (PAEK) include polyether ketone (PEK), polyether ether ketone (PEEK), polyether ketone ketone (PEKK), and polyether ether ketone ketone (PEEKK).

When a polyamide 6 is produced as the thermoplastic resin, $\epsilon$-caprolactam is used as the cyclic compound. When a polyamide 12 is produced as the thermoplastic resin, $\omega$-laurolactam is used. When a polyamide 612 is produced as the thermoplastic resin, $\epsilon$-caprolactam and $\omega$-laurolactam are used in combination.

In one embodiment of the production method according to the present disclosure, the thermoplastic resin is generated by a ring-opening polymerization of a cyclic compound capable of undergoing ring-opening polymerization in a state of a mixture of the cyclic compound and an inorganic filler.

(Mixture)

A mixture comprising an inorganic filler and a monomer and/or oligomer of a thermoplastic resin can be provided, for example, by adding the inorganic filler to the monomer and/or oligomer of the thermoplastic resin, followed by mixing and/or kneading of the mixture.

For mixing and/or kneading, common kneading device such as a paint shaker or a bead mill, a planetary mixer, a stirring disperser, a self-rotating stirring mixer, a three roll mill, a kneader, or a single or twin-screw kneader can be used. Depending on the conditions of mixing and/or kneading, it is possible to control the average particle diameter of the obtained composite particles.

The monomer and/or oligomer of the thermoplastic resin and the inorganic filler, in particular the cyclic compound and the inorganic filler, are preferably mixed uniformly.

Mixing may be performed in advance, or may be performed at the time of the polymerization. It is preferable that the mixing and/or kneading is performed in advance as well as during the polymerization.

(Melting of the monomer and/or oligomer)

In the provision step, the monomer and/or oligomer are in a liquid state and cover the primary particles of the inorganic filler.

Although there is no intention to limit the present invention by theory, it is considered that, since the primary particles of the inorganic filler are covered with the monomer and/or oligomer in the provision step, the primary particles of the inorganic filler are relatively well covered by the thermoplastic resin in the composite particles according to the present disclosure.

When the monomer and/or oligomer is not liquid at normal temperature and pressure (25°C, 1 atm), the monomer and/or oligomer can be made liquid, for example, by heating and melting the monomer and/or oligomer at a temperature equal to or more than the melting point of the monomer and/or oligomer. By adding an inorganic filler to the monomer and/or oligomer thus melted and by appropriately stirring, the primary particles of the inorganic filler can be covered with the monomer and/or oligomer.

Preferably, the monomer and/or oligomer has a relatively high wettability to the inorganic filler.

(Catalyst)

In one embodiment according to the present disclosure, the mixture provided in the provision step may comprise a catalyst.

It is preferable to use a catalyst in order to accelerate the polymerization reaction of the monomer and/or oligomer, in particular the ring-opening polymerization reaction of the cyclic compound. Known catalysts may be used as the catalyst, depending on the monomer and/or oligomer used.

The optimal catalyst may vary, for example, depending on the type of the cyclic compound which is used as the monomer and/or oligomer. Known catalysts can be used as the catalyst for each of the ring-opening polymerization reaction of the cyclic compound.

For example, when ε-caprolactam is used as the cyclic compound, sodium, potassium, lithium, and/or magnesium bromide can be used as the catalyst for ring-opening polymerization reaction.

An accelerator for the ring-opening polymerization reaction may be used in combination with the catalyst. An isocyanate compound or a carbodiimide compound can be used as the accelerator.

(Additives)

In one embodiment of the method for producing the composite particle according to the present disclosure, the mixture provided in the provision step may contain an additive. When the cyclic compound is used as the monomer and/or oligomer of the thermoplastic resin, the additive is preferably added within a range that does not inhibit the ring-opening polymerization of the cyclic compound.

Examples of the additive include a curing accelerator, an anti-discoloration agent, a surfactant, a coupling agent, a colorant, and a viscosity modifier.

<Reaction step>

In the reaction step of the production method according to the present disclosure, the monomer and/or oligomer are polymerized to form a random-shaped composite particle in which the primary particles of the inorganic filler are aggregated and the primary particles are coated with the thermoplastic resin.

(Polymerization of the monomer and/or oligomer)

The polymerization reaction of the monomer and/or oligomer can be carried out, for example, by subjecting the mixture provided in the provision step to a heat treatment under an inert atmosphere while mixing and stirring.

Examples of the inert atmosphere include nitrogen atmosphere and argon atmosphere.

The heating temperature in the heating treatment is not particularly limited, but may be appropriately set depending on the monomer and/or oligomer used. Preferably, the heating temperature is lower than the melting point of the thermoplastic resin to be obtained by the polymerization of the monomer and/or oligomer.

For example, the heating temperature may range from 150°C to 200°C when ε-caprolactam is used as the monomer.

<<Composite particle>>

The present disclosure also relates to a random-shaped composite particle formed of aggregated primary particles of an inorganic filler, in which the primary particles are coated with a thermoplastic resin.

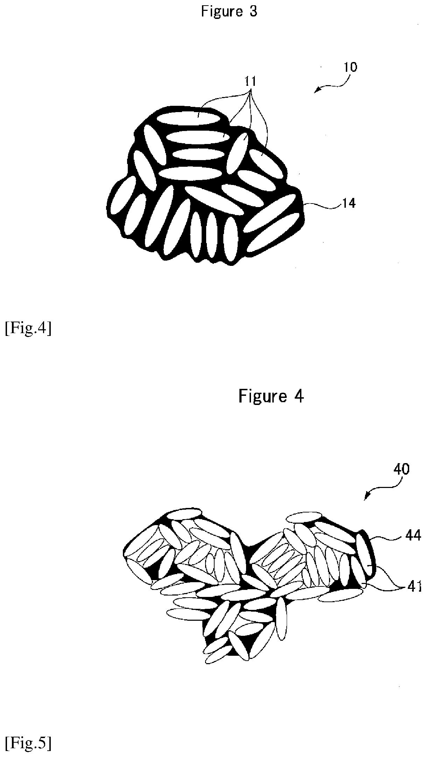

Fig.4 is a cross-sectional schematic view of an embodiment of a thermoplastic resin composition having a filler according to the prior art. In this thermoplastic resin composition 40, the thermoplastic resin 44 and the inorganic filler 41 are not well mixed. In other words, the inorganic filler 41 is not well dispersed in the thermoplastic resin 44. Such a resin composition occurs, for example, when the amount of the inorganic filler is excessively high relative to the thermoplastic resin.

In such a resin composition, voids are generated in a molded product of the resin, and there are problems that the impact resistance is decreased and the high thermal conductivity is not obtained due to the voids. In addition, when the dispersibility of the inorganic filler in the thermoplastic resin is low, the moldability of the thermoplastic resin composition may be inferior.

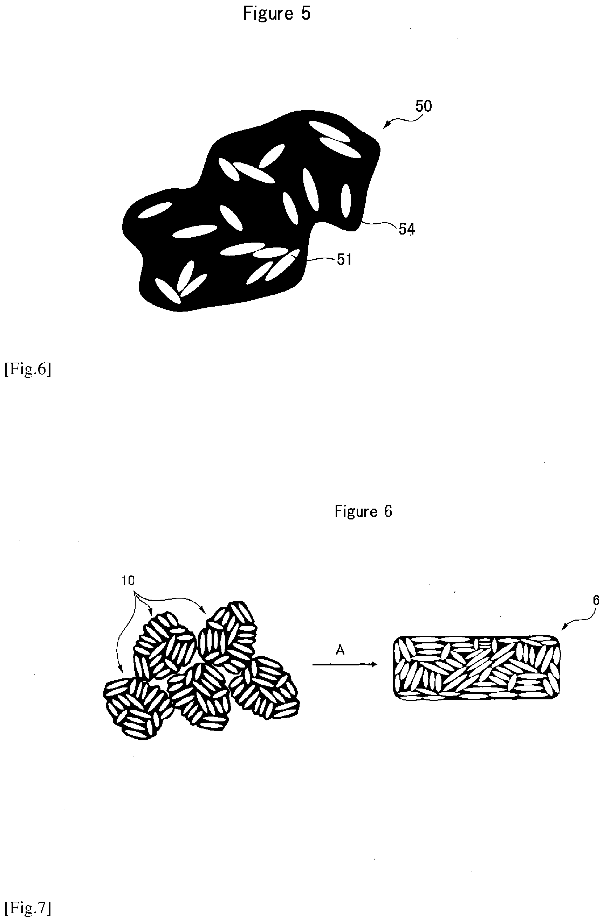

Fig.5 is a cross-sectional schematic view of another embodiment of a thermoplastic resin composition having a filler according to the prior art. In this thermoplastic resin composition 50, the inorganic filler 51 is relatively well dispersed in the thermoplastic resin 54, but the cohesiveness of the inorganic filler 51 is low. Such a resin composition may occur, for example, when the fluidity of an inorganic filler in a thermoplastic resin is high. Such a resin composition cannot fully utilize the high thermal conductivity inherent to the inorganic filler.

On the other hand, in the composite particle according to the present disclosure, an inorganic filler retaining an aggregated state is tightly coated with a thermoplastic resin.

FIG. 3 is a schematic cross-sectional view of the composite particle 10 according to the present disclosure. In this composite particle 10, primary particles 11 of the inorganic filler are coated with the thermoplastic resin 14, and primary particles 11 of the inorganic filler are aggregated by bonding to each other via the thermoplastic resin 14.

Although there is no intention to limit the present invention by theory, in the composite particles according to the present disclosure, the primary particles of the inorganic filler are bonded to each other via the thermoplastic resin. Therefore, it is considered that the aggregation state of the primary particles of the inorganic filler is retained, resulting in the high thermal conductivity of the composite particle. In other words, the composite particle according to the present disclosure can effectively develop high thermal conductivity by using an aggregated inorganic filler.

Further, although there is no intention to limit the present invention by theory, in the composite particles according to the present disclosure, the primary particles of the inorganic filler are covered with the thermoplastic resin; this means that the inorganic filler and the thermoplastic resin are highly mixed. Therefore, according to the composite particles of the present disclosure, it is considered that the inorganic filler can be uniformly dispersed in the thermoplastic resin of the molded article. Accordingly, according to the present disclosure, there is provided a composite particle having excellent moldability.

In addition, in the composite particle according to the present disclosure, since the inorganic filler is covered with a thermoplastic resin, it has high insulating property.

Further, since the composite particle according to the present disclosure is particulate, they exhibit excellent handling properties during the molding process or the like.

Therefore, the composite particle according to the present disclosure can provide a composite particle having sufficient insulating properties and high thermal conductivity. Further, according to the present invention, it is possible to provide a composite particle excellent in handling properties and moldability.

The composite particle according to the present disclosure can be produced by the above-described manufacturing method according to the present disclosure.

For example, the composite particle of the present disclosure can be produced according to the manufacturing method of the present disclosure, by subjecting a cyclic compound capable of undergoing ring-opening polymerization to a ring-opening-polymerization reaction in a state of a mixture of the cyclic compound and an aggregated inorganic filler, and by forming a thermoplastic resin binder.

<Random-shaped composite particles>

The composite particle according to the present disclosure is a random-shaped composite particle, and the shape thereof is not particularly limited. The shape of the composite particle may be, for example, spherical, scaly, or fibrous. Note that, in the context of the present application, "random-shaped" means that the composite particle is not molded by a mold or the like.

<Inorganic filler>

Examples of the inorganic filler include a particle of aluminum nitride, silica, alumina, magnesium oxide, silicon nitride, boron nitride, or zinc oxide, or a silicone particle provided with a coating of an insulating layer. Among these, preferred inorganic fillers are a boron nitride particle or a silicone particle coated with an insulating layer. The boron nitride may be either hexagonal or cubic. From the viewpoint of obtaining excellent thermal conductivity, hexagonal boron nitride is preferred.

In one embodiment according to the present disclosure, the inorganic filler is a boron nitride particle or a silicone particle provided with a coating of an insulating layer.

The inorganic filler may be used alone or in combination. The shape of the primary particle of the inorganic filler is not limited, and may be for example spherical, scaly, or fibrous.

The particle size of the primary particle of the inorganic filler is, for example, 0.1 to 200$\mu$m, 1 to 100$\mu$m, and preferably 10 to 50$\mu$m as average particle diameter.

The particle size of the aggregated particles of the inorganic filler, i.e., the particle size of the composite particle is, for example, 1$\mu$m to 1000$\mu$m, preferably 10$\mu$m to 500$\mu$m, and particularly preferably 20$\mu$m to 300$\mu$m, as average particle diameter. When the average particle size of the composite particle is in this range, satisfactory moldability can be achieved.

<Thermoplastic resin>

Examples of the thermoplastic resin include polyamide, polyester, polycarbonate, polyether, polysulfide, and polyarylene ether ketone (PAEK), and preferably polyamide is used. As the polyamide, polyamide 6, polyamide 12 and polyamide 612 are particularly preferable. Examples of the polyarylene ether ketone (PAEK) include polyether ketone (PEK), polyether ether ketone (PEEK), polyether ketone ketone (PEKK), and polyether ether ketone ketone (PEEKK)

In one embodiment according to the present disclosure, the thermoplastic resin is a thermoplastic resin generated by a ring-opening polymerization of a cyclic compound capable of undergoing ring-opening polymerization in a state of a mixture of an inorganic filler and the cyclic compound.

The composite particle of the present disclosure preferably comprises 51.0% by volume to 99.9% by volume of the inorganic filler and 49.0% by volume to 0.1% by volume of the thermoplastic resin. If the amount of the inorganic filler is too small or the amount of the thermoplastic resin is too large, the particles aggregate and grow too large, so that it becomes difficult to form a particle shape, which is not preferable. If the amount of the inorganic filler is too large or the amount of the thermoplastic resin is too small, the thermoplastic resin is unable to coat the inorganic filler, which is not preferable.

In one embodiment of the composite particle according to the present disclosure, in the composite particle, the inorganic filler is preferably 51.0% by volume or more, 55.0% by volume or more, 60.0% by volume or more, 65.0% by volume or more, 70.0% by volume or more, and/or 99.9% by volume or less, 99.0% by volume or less, 95.0% by volume or less, 90.0% by volume or less, 85.0% by volume or less, 80.0% by volume or less, or 75.0% by volume or less, and the thermoplastic resin is preferably 0.1% by volume or more, 1.0% by volume or more, 5.0% by volume or more, 10.0% by volume or more, 15.0% by volume or more, 20.0% by volume or more, or 25.0% by volume or more, and/or 49.0% by volume or less, 45.0% by volume or less, 40.0% by volume or less, 35.0% by volume or less, or 30.0% by volume or less.

<<Manufacturing method of a molded article>>

The present disclosure also relates to a method of manufacturing a molded article comprising pressing the composite particle according to the present disclosure.

FIG. 6 is a conceptual diagram of a manufacturing process of a molded article using the composite particle according to the present disclosure. As can be seen in FIG. 6, a plurality of the composite particles 10 according to the present disclosure can be subjected to a pressing process "A" after optionally put into a mold or the like, in order to produce a molded article 6.

In the composite particle 10 according to the present disclosure, primary particles of the inorganic filler are covered with a thermoplastic resin, and the primary particles are aggregated. Although there is no intention to limit the present invention by theory, in such composite particles according to the present disclosure, the thermoplastic resin and the inorganic filler is relatively highly mixed. Therefore, it is considered that the separation of the thermoplastic resin and the inorganic filler is avoided in the molding process. As a result, by using the composite particle according to the present disclosure, it is possible to obtain a molded article having high dispersibility of the inorganic filler while maintaining high thermal conductivity.

The method for pressing the composite particle is not particularly limited. For example, the composite particle may be pressed by using a known press.

The molded article produced by the method according to the present disclosure may be in the form of a sheet. The molded article produced by the method according to the present disclosure may be a sheet, and in particular a thermally conductive insulating sheet.

<<Molded article>>

The present disclosure includes a molded article obtained by pressing the composite particle according to the present disclosure.

According to the composite particle of the present disclosure, the inorganic filler and the thermoplastic resin are in a highly mixed state; and the inorganic filler can be uniformly dispersed in the thermoplastic resin within a molded article formed from the composite particle of the present disclosure. Therefore, according to the composite particle of the present disclosure, it is possible to provide a molded article having high conductivity and high insulating property.

Therefore, according to the molded article of the present disclosure, it is possible to provide a molded article having high conductivity and high insulating property.

In one embodiment according to the present disclosure, the molded article is in the form of a sheet.

In another embodiment according to the present disclosure, the mold article is a sheet, and in particular a thermally conductive insulating sheet.

In yet another embodiment according to the present disclosure, the molded article has a thermal conductivity of 1W/m·K to 20W/m·K and a specific resistance of $1.0 \times 10^{14}$ Ω·cm to $20.0 \times 10^{15}$ Ω·cm.

The molded article may have a thermal conductivity of 1. 0 W/m·K or more, 2. 0 W/m·K or more, and/or 20 W/m·K or less, 15 W/m·K or less, 10 W/m·K or less, or 8 W/m·K or less.

The molded article may have a specific electrical resistivity of $1.0 \times 10^{14}$ Ω·cm or more, or $2.0 \times 10^{14}$ Ω·cm or more, and/or $20 \times 10^{15}$ Ω·cm or less, $15 \times 10^{15}$ Ω·cm or less, or $10 \times 10^{15}$ Ω·cm or less.

[Industrial Applicability]

The composite particle of the present disclosure can be used as a thermally conductive insulating sheet by, for example, shaping them into the shape of a sheet. The thermally conductive insulating sheet can be used as a heat dissipation sheet of an electronic member such as a semiconductor, and can also be used as a printed circuit board. Shaping to a sheet-like shape can be performed, for example, by a press molding.

[EXAMPLES]

Hereinafter, the invention according to the present disclosure will be described in detail with reference to the examples.

Composite particles according to Examples 1 and 2 and a resin composition according to Comparative example 1 were prepared for the evaluation of physical properties. In addition, evaluation of the moldability and the physical properties of the molded articles were carried out on these composite particles and the resin composition.

In the evaluation of physical properties, measurements were performed according to the following methods.

<(1) Thermal conductivity>

Thermal conductivity was calculated according to the following formula, by multiplying a thermal diffusivity in the thickness direction of the sample, a specific heat, and a specific gravity.

$$\text{(Thermal conductivity)} = \text{(Thermal diffusivity)} \times \text{(Specific heat)} \times \text{(Specific gravity)}$$

Thermal diffusivity in the thickness direction was determined by a laser flash method in a sample processed to a size of 10 mm of width × 10 mm × 0.1 to 1 mm of thickness. A xenon flash analyzer (LFA467 HyperFlash, manufactured by NETZSCH) was used as a measuring device. Specific gravity was determined from the volume and the weight of the sample. Specific heat was determined using a differential scanning calorimeter (DSC8000 from Perkin Elmer, Inc.).

<(2) Specific resistance>

In a sample processed to a size of 10 mm of width × 10 mm × 0.1 to 1 mm of thickness, electrodes were formed with a silver paste on one surface of the sample (surface of 10mm×10mm) and the opposite surface thereof, and the resistance value was measured between the two electrodes at an applied voltage of 1000 V. Resistivity measurement device (manufactured by Nishiyama Seisakusho Co., Ltd.) was used as the measurement device. The specific resistance was calculated according to the following equation.

$$\text{(Specific resistance)} = \text{(Resistance value)} \times \text{(Area of electrode)}/\text{(Sample thickness)}$$

<(3) Diameter of the composite particle>

Composite particles were dispersed in water to measure the average particle size of the composite particle. Particle size distribution meter (MT3000 by MicrotracBEL Corp.) was used as the measuring equipment.

<(4) Reaction rate of the ring-opening polymerization>

Heat extraction was performed in a solvent, and the concentration of cyclic compounds in the extract was measured using gas chromatography, and the reaction rate was calculated. The solvent may be any solvent which dissolves the cyclic compound and which does not dissolve the resin obtained by the ring-opening polymerization. The heating temperature may be a temperature at which the cyclic compound is sufficiently extracted. When ε-caprolactam was used as the cyclic compound, extraction was carried out at 105 °C under pressure using water as a solvent.

<(5) Average particle diameter of the primary particle>

The particle size was measured by dispersing the inorganic filler in water. Particle size distribution meter (MT3000 by MicrotracBEL Corp.) was used for the measuring equipment.

<<Example 1>>

The composite particle according to Example 1 was produced as described below. In addition, the physical properties of the obtained composite particle were measured. Further, the obtained composite particle was used to produce a molded article.

<Preparation of the composite particle>

An ε-caprolactam as a monomer of a thermoplastic resin was prepared, and an ε-caprolactam sodium salt as an anionic polymerization catalyst was added so as to be 1.7mol% based on the ε-caprolactam to prepare a mixed solution. Dicyclohexylcarbodiimide as a reaction accelerator was added to the mixed solution so as to be 1.7mol% and completely dissolved to obtain a reaction solution. Subsequently, hexagonal boron nitride (organically modified boron nitride (average particle diameter of the primary particle: 41.2μm), manufactured by ITEC Co.,LTD) was used as an inorganic filler, and the mixture was obtained by mixing and stirring so that the weight ratio of the inorganic filler and the reaction solution was 4.8:1.0.

Then, the mixture was heated under a nitrogen atmosphere at 170 °C for 15 minutes while stirring, and the monomer was subjected to a polymerization reaction to obtain a composite particle containing polyamide 6 as the thermoplastic resin and boron nitride as the inorganic filler. The composite particle comprised 72 % by volume of boron nitride as the inorganic filler and 28 % by volume of the thermoplastic resin.

The unreacted ε-caprolactam was extracted by heating the obtained composite particle, and measured by gas chromatography, and the reaction rate was determined as 98%.

<Measurement of the physical properties of the composite particle>

The average particle diameter of the obtained composite particle was 94.5μm.

A cross section of the particle was observed (at a magnification of 1000 times) using SEM (JCM-6000 by JEOL Ltd.).

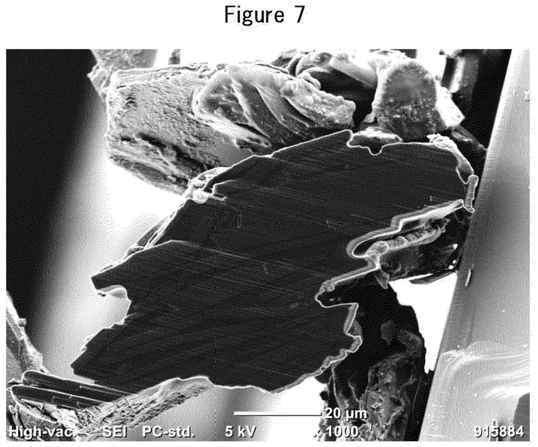

The result is shown in Fig. 7. As seen in FIG. 7, it was confirmed that in the composite particle, aggregated particles of hexagonal boron nitride were impregnated and covered with polyamide 6 to form the composite particle. Therefore, it has been found that, by the above-described manufacturing method according to Example 1, a random-shaped composite particle is obtained, in which primary particles of the inorganic filler are aggregated and the primary particles are coated with the thermoplastic resin.

<Production of a molded article>

Then, by press-molding the obtained composite particles, a thermal conductive insulating sheet having a thickness of 1mm was obtained as a molded article.

The obtained thermally conductive insulating sheet has a thermally conductivity of 6.8 W/m·K and a specific resistance of $9.0 \times 10^{15}$ Ω·cm.

< Example 2>

The composite particle was produced in the same manner as in Example 1, except that a silicone particle provided with a coating of an insulating layer was used as the inorganic filler and mixed and stirred so that the weight ratio of the inorganic filler and the reaction liquid was 4.2:1.0. The composite particle comprised 65 % by volume of the above silicone particle as the inorganic filler and 35% by volume of the thermoplastic resin.

Unreacted ε-caprolactam was extracted by heating the obtained composite particle, and measured by gas chromatography, and the reaction rate was determined as 98 %.

By observing a cross section of the particle using SEM (at a magnification of 1000 times in the same device as in Example 1), it was confirmed that the aggregated silicone particles were impregnated and coated with polyamide 6 to form the composite particle. Therefore, it has been found that, by the above manufacturing method according to Example 2, a random-shaped composite particle is obtained, in which primary particles of the inorganic filler are aggregated and the primary particles are coated with the thermoplastic resin.

A thermally conductive insulating sheet with the thickness of 1mm was obtained by press-molding the composite particle. The obtained thermally conductive insulating sheet had a thermal conductivity of 2.6 W/m·K and a specific resistance of $3.1 \times 10^{14}$ Ω·cm.

<Comparative Example 1>

27 % by volume of a powdery polyamide 6 resin as the thermoplastic resin and 73 % by volume of a hexagonal boron nitride as the inorganic filler were heated to 250°C, and melt-mixed in a LABO PLASTOMILL.

The resulting resin composition could not take the form of a composite particle.

Subsequently, a press molding was attempted using the obtained resin composition, but the inorganic fillers were not impregnated by the thermoplastic resin, and a sheet could not be obtained.

[REFERENCE SIGNS]

| | |
|---|---|
| 10 | composite particle |
| 11 | primary particle of an inorganic filler |
| 13 | liquid-state monomers and/or oligomers of a thermoplastic resin |
| 14, 24, 44, 54 | thermoplastic resin |
| 15 | mixture |
| 20, 40, 50 | thermoplastic resin composition |
| 21, 41, 51 | inorganic filler |
| 6 | molded article |
| A | pressing treatment |
| M | mixing treatment |
| P | polymerization reaction |

**Claims**

1. A method for producing a random-shaped composite particle formed of aggregated primary particles of an inorganic filler, in which the primary particles are coated with a thermoplastic resin, comprising:

   (1) providing a mixture comprising the inorganic filler and a monomer and/or oligomer of the thermoplastic resin, wherein said monomers and/or oligomers are in a liquid-state and cover the primary particles of the inorganic filler; and
   (2) polymerizing the monomer and/or oligomer to form a random-shaped composite particle in which the primary particles of the inorganic filler are aggregated and the primary particles are coated with the thermoplastic resin.

2. The method according to claim 1, wherein the monomer and/or oligomer of the thermoplastic resin is a cyclic compound capable of undergoing ring-opening polymerization.

3. The method according to claim 2, **characterized in that** the thermoplastic resin is generated by ring-opening polymerization of the cyclic compound capable of undergoing ring-opening polymerization in a state of a mixture of the cyclic compound and the inorganic filler.

4. The method according to any one of claims 1 to 3, wherein the thermoplastic resin is a polyamide.

5. The method according to any one of claims 2 to 4, wherein the cyclic compound is ε-caprolactam and/or ω-laurolactam.

6. The method according to any one of claims 1 to 5, wherein the inorganic filler is a boron nitride particle or a silicone particle provided with a coating of an insulating layer.

7. A random-shaped composite particle formed of aggregated primary particles of an inorganic filler, in which the primary particles are coated with a thermoplastic resin.

8. The composite particle according to claim 7, comprising 51.0 to 99.9% by volume of the inorganic filler and 49.0 to 0.1% by volume of the thermoplastic resin.

9. The composite particle according to claim 7 or 8, wherein the average particle diameter of the composite particle is 1$\mu$m to 1000$\mu$m.

10. The composite particle according to any one of claims 7 to 9, wherein the thermoplastic resin is a polyamide.

11. The composite particle according to claim 10, wherein the polyamide is polyamide 6, polyamide 12 or polyamide 612.

12. The composite particle according to any one of claims 7 to 11, wherein the inorganic filler is a boron nitride particle or a silicone particle provided with a coating of an insulating layer.

13. The composite particle according to any one of claims 7 to 12, wherein the thermoplastic resin is a thermoplastic resin generated by a ring-opening polymerization of a cyclic compound capable of undergoing ring-opening polymerization in a state of a mixture of the inorganic filler and the cyclic compound.

14. A method for producing a molded article comprising pressing the composite particles according to any one of claims 7 to 13.

15. A molded article obtained by pressing the composite particles according to any one of claims 7 to 13.

16. The molded article according to claim 15, which is in the form of a sheet.

[Fig.1]

Figure 1

[Fig.2]

Figure 2

[Fig.3]

Figure 3

[Fig.4]

Figure 4

[Fig.5]

Figure 5

[Fig.6]

Figure 6

[Fig.7]

Figure 7

## INTERNATIONAL SEARCH REPORT

International application No.

PCT/JP2019/022234

### A. CLASSIFICATION OF SUBJECT MATTER

Int.Cl.    C08L77/02(2006.01)i,    C08K3/02(2006.01)i,    C08K3/38(2006.01)i,
           C08K5/3412(2006.01)i, C09C1/00(2006.01)i, C09C3/10(2006.01)i

According to International Patent Classification (IPC) or to both national classification and IPC

### B. FIELDS SEARCHED

Minimum documentation searched (classification system followed by classification symbols)

Int.Cl. C08L77/02, C08K3/02, C08K3/38, C08K5/3412, C09C1/00, C09C3/10

Documentation searched other than minimum documentation to the extent that such documents are included in the fields searched

| | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2010-514876 A (ARKEMA FRANCE) 06 May 2010, claims, paragraph [0017], examples & US 2010/0113661 A1, claims, paragraph [0037], examples & WO 2008/087335 A2 & FR 2910900 A1 & CN 101578319 A & KR 10-2009-0103892 A & AU 2007344279 A & MX 2009007035 A & RU 2009128969 A & BR PI0720716 A | 1-16 |

☒ Further documents are listed in the continuation of Box C.　　☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 21 August 2019 (21.08.2019) | 03 September 2019 (03.09.2019) |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

**INTERNATIONAL SEARCH REPORT**

International application No.

PCT/JP2019/022234

C (Continuation).   DOCUMENTS CONSIDERED TO BE RELEVANT

| Category* | Citation of document, with indication, where appropriate, of the relevant passages | Relevant to claim No. |
|---|---|---|
| X | JP 2014-501309 A (SHANGHAI GENIUS ADVANCED MATERIAL (GROUP) CO., LTD.) 20 January 2014, claims, examples & US 2014/0048738 A1, claims, examples & WO 2012/089081 A1 & EP 2660268 A1 & CN 102585493 A & KR 10-2013-0108453 A | 1-16 |
| X A | JP 2008-519879 A (ARKEMA FRANCE) 12 June 2008, claims, examples & US 2009/0075081 A1, claims, examples & WO 2006/051222 A2 & FR 2877948 A1 & KR 10-2007-0086033 A & CN 101098915 A & RU 2007121584 A & ES 2416332 T & UA 83162 C | 1-7, 9-16 8 |
| E, A | JP 2019-131669 A (TEIJIN LTD.) 08 August 2019, claims, paragraphs [0014]-[0018], examples (Family: none) | 1-16 |

Form PCT/ISA/210 (continuation of second sheet) (January 2015)

**EP 3 845 603 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002280498 A
- JP 2003342021 A
- JP 2005209765 A
- JP H10204300 A
- JP 2010116518 A